Europäisches Patentamt

European Patent Office

Office européen des brevets

(19)

(11) Publication number: **0 366 199**

**A1**

(12) **EUROPEAN PATENT APPLICATION**

(21) Application number: 89202673.3

(22) Date of filing: 23.10.89

(51) Int. Cl.5: **H04N 5/335 , H04N 3/15**

(30) Priority: 27.10.88 NL 8802642

(43) Date of publication of application:
02.05.90 Bulletin 90/18

(84) Designated Contracting States:
**AT DE ES FR GB**

(71) Applicant: **N.V. Philips' Gloeilampenfabrieken**
**Groenewoudseweg 1**
**NL-5621 BA Eindhoven(NL)**

(72) Inventor: **Esser, Leonard Jan Maria**
**c/o INT. OCTROOIBUREAU B.V. Prof.**
**Holstlaan 6**
**NL-5656 AA Eindhoven(NL)**

(74) Representative: **Kooiman, Josephus Johannes**
**Antonius et al**
**INTERNATIONAAL OCTROOIBUREAU B.V.**
**Prof. Holstlaan 6**
**NL-5656 AA Eindhoven(NL)**

(54) **Image pick-up device comprising a frame transfer sensor suitable for information transfer in accordance with the accordion principle.**

(57) The sensor (FT) comprises an image section (IP) and a storage section (SP) and a parallel-in, series-out shift register section (SR), both shielded from radiation . The image pick-up device also comprises a shutter device (SH, SHM) for interrupting the incidence of radiation on the image section (IP) during a period for the information transfer (FTD) in accordance with the accordion principle. In the case of a partially local interruption of the incidence of radiation on the image section (IP) the information transfer in accordance with the accordion principle locally starts at this interruption and follows it with the continuing local interruption of the incidence of radiation. An improved picture quality is obtained when displaying the generated picture signal because of the even transfer which is thus obtained instead of the known abrupt transfer following a total interruption of incidence of radiation.

FIG.1

# Image pick-up device comprising a frame transfer sensor suitable for information transfer in accordance with the accordion principle.

The invention relates to an image pick-up device comprising a frame transfer sensor suitable for information transfer in accordance with the accordion principle, which sensor comprises an image section comprising sensor image elements for converting incident radiation into charge packet information as picture information, a storage section coupled thereto and shielded from radiation for the purpose of picture information storage comprising sensor storage elements and a parallel-in, series-out shift register section coupled thereto and shielded from radiation comprising at least one row of sensor shift register elements and having at least one output for supplying a picture signal, the device for performing the accordion control including a time signal generator for applying at least clock pulse signals to control electrodes of the sensor, the information transfer in accordance with the accordion principle involving an information shift in the sensor with an openening, a transporting and a closing phase, the opening phase involving an enlargement of picture information elements and a transport of picture information, the transporting phase involving a transport of picture information and the closing phase involving a transport of picture information and a reduction of picture information elements at the appointed locations, said image pick-up device further including a shutter device for interrupting the incidence of radiation on the image section during a period for the information transfer in accordance with the accordion principle.

An image pick-up device comprising a frame transfer sensor suitable for information transfer in accordance with the accordion principle is known from the Article "The accordion imager, a new solid-state image sensor" in the Journal Philips Technical Review, No. 1/2, December 1986, pp. 1 to 8. This Article describes that the transfer should be very fast to ensure that the charge packets which are on their way are not significantly influenced by incident light such as radiation.

To prevent this influence, it is generally known to use the shutter device. The shutter device generally has a rotary disc which is secured to a shaft driven by a motor. To interrupt the incidence of light, the rotary disc is rotated in front of the image section. If the image section is completely shielded by the rotary disc after a period of rotating the disc, the frame transfer is subsequently effected during the transfer period. This transfer may be or may not be effected in accordance with the accordion principle.

In practice it appears that a disturbance may occur in the picture when displaying the picture which is formed in a line and field-sequential manner. Objects with vertical contours moving in the line scan direction or horizontal direction appear to be displayed with non-vertical, but oblique contours. The contour cants in the direction of movement.

It is an object of the invention inter alia to reduce this disturbance when using the information transfer in accordance with the accordion principle. To this end an image pick-up device according to the invention is characterized in that in the case of a partially local interruption of the incidence of radiation on the image section the information transfer in accordance with the accordion principle locally starts at said interruption and follows it with the continuing local interruption of the incidence of radiation.

The image disturbance is reduced by using the extension of the accordion transfer which follows the continuing interruption of radiation. In fact, this image disturbance is caused by the fact that the image information in the image section during the known frame transfer period of five to seven line periods is removed therefrom in one abrupt action and that the display is effected pixel and line-sequentially in a field period. The human eye interprets the display of two offset images of the vertical contour as an oblique contour canting in the direction of movement. In the frame transfer according to the invention the abrupt action does not occur, but an even transfer takes place.

The invention will be described in greater detail by way of example with reference to the accompanying drawings in which

Fig. 1 shows diagrammatically an image pick-up device according to the invention, with a frame transfer sensor and a shutter device;

Figs. 2a, 2b, 2c and 2d illustrate four positions occurring in time of the sensor image section to explain the operation of the image pick-up device according to Fig. 1, and

Fig. 3 shows a pattern of logic 0s and 1s occurring at control electrodes of the sensor, related to the said four positions.

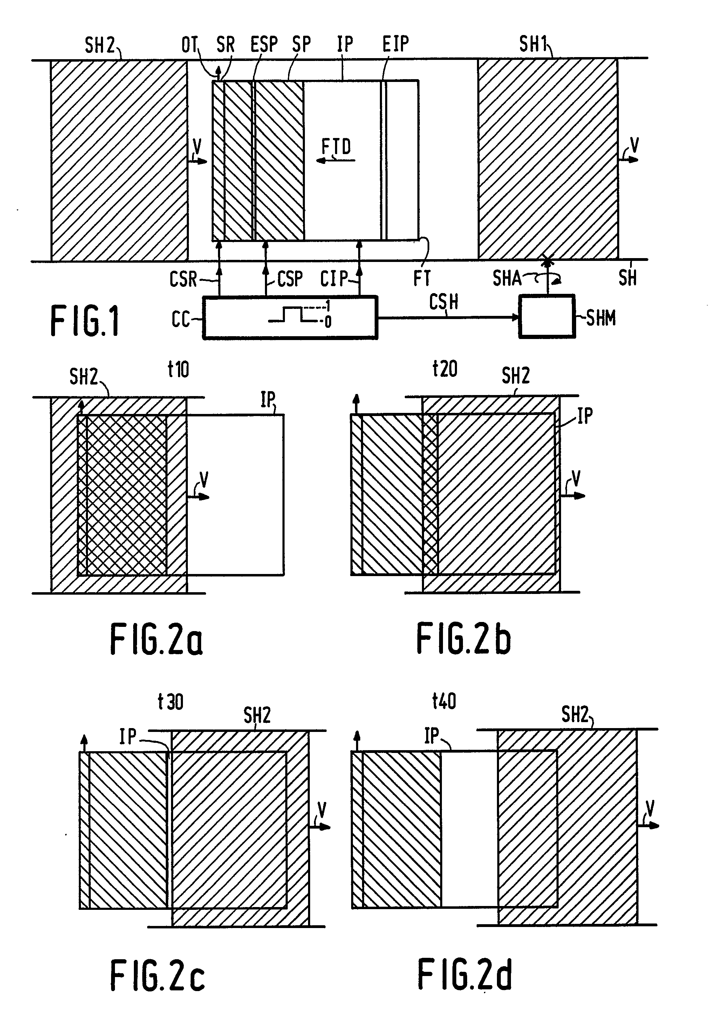

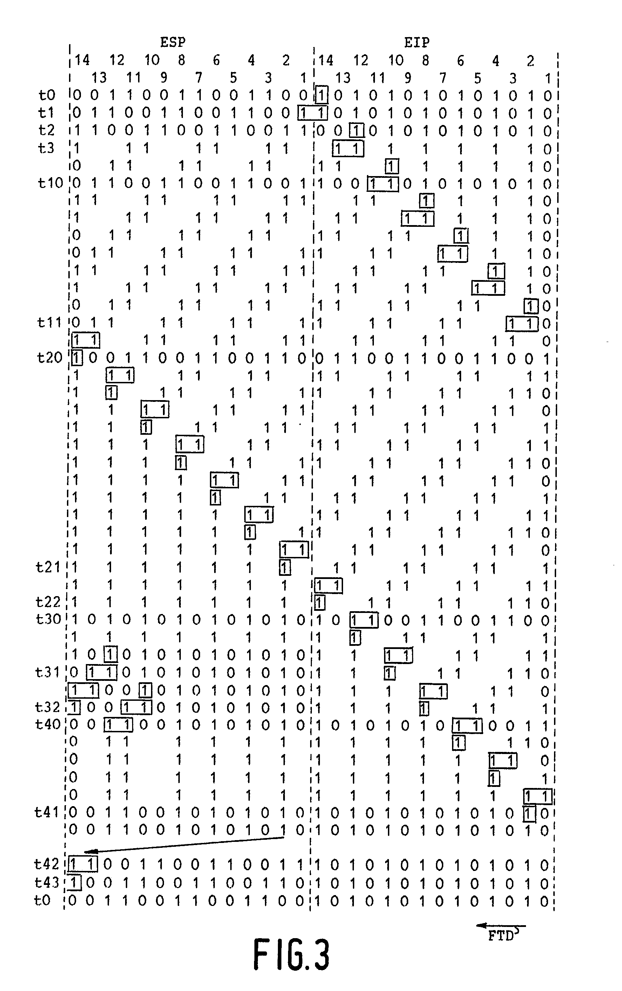

In Fig. 1 the reference FT denotes a frame transfer sensor. An image section IP, a storage section SP and a shift register section SR are denoted at the sensor FT. The sections IP and SP comprise in known manner a two-dimensional pattern of sensor elements each (not shown). Numbers and formats of the sensor elements in the patterns may be equal or different. The section IP comprises sensor image elements for converting incident radiation such as, for example light into charge packet information as picture information. The storage section SP shielded from radiation for picture information storage comprises sensor storage elements. The parallel in, series out shift register section SR which is also shielded from radiation comprises at least one row of sensor shift register elements, which row is connected to at least one output OT for supplying a picture signal. The shieldings are indicated by means of shaded areas. Sensor control electrodes at the sections IP and SP are illustrated with reference to single electrodes EIP and ESP, respectively. The electrodes EIP and ESP are further shown in Fig. 3 which gives a pattern of logic 0s and 1s occurring at fourteen electrodes each. The pattern given is associated with an information transfer in accordance with the accordion principle, and the direction of this transfer is denoted by an arrow FTD in Figs. 1 and 3. The pattern of Fig. 3 is obtained by means of clock pulse signals CIP and CSP which are supplied by a time signal generator CC. The generator CC also applies a clock pulse signal CSR to the register section SR. The leads conveying the signals CIP, CSP and CSR are shown as a single leads but are formed as multiple leads in known manner for the transport of the various clock pulse signals at different frequencies or phases. The frame transfer sensor FT shown may be combined with a so-called interline sensor IL to a FIT sensor.

Fig. 1 also shows a shutter device (SH, SHM) which consists of, for example a shutter pair SH shown with two shutters SH1 and SH2 and with a motor SHM which is coupled to the shutter pair SH via a drive shaft with a drive direction indicated by an arrow SHA. Since the shutter device (SH, SHM) is to be driven synchronously with the electrode control at the sensor FT, the generator CC applies a synchronizing signal CSH to the motor SHM. The shutter device (SH, SHM) is shown by way of example in Fig. 1. The motor SHM ensures that the shutters SH1 and SH2 move in front of the sensor FT at a speed indicated by an arrow v so that the incidence of radiation or light on the image section IP is interrupted during a period for the information transfer from image section IP to storage section SP. The interruption of the incidence of light is illustrated by means of a shaded area. Instead of the mechanical solution shown, an electronic shutter in front of the image section IP is feasible, which is formed, for example with a liquid crystal. The liquid crystal should be controlled in such a way that a shutter action occurs which is illustrated for Fig. 1 in Figs. 2a, 2b, 2c and 2d.

Figs. 2a, 2b, 2c and 2d are associated with four positions, occurring in time, of the image section IP and the shutter SH2, subsequent to the position of the sensor FT and the shutters SH1 and SH2 shown in Fig. 1.

Fig. 2a shows at an instant t10 that a small part of the image section IP is shielded. Fig. 2b shows that at an instant t20 the entire section is shielded. Fig. 2c is associated with an instant t30 occurring just after exposing the image section IP to light. The further exposure is shown in Fig. 2d at an instant t40.

The instants t10, t20, t30 and t40 are shown as examples in Fig. 3 at the logic pattern. The reference t0 denotes an instant used as a periodical instant for the description of the operation of the image pick-up device according to Fig. 1. A logic pattern 01010101 etc. is present as an example at the control electrodes EIP1 to 14 of the image section IP. It is assumed in known manner that the logic 0 corresponds to a barrier induced in the sensor FT and the logic 1 corresponds to a potential well which may comprise a charge packet occurring in the sensor FT as picture information which is locally built up during a picture integration period. Furthermore it is assumed that at the instant t0 a logic pattern 00110011 etc. is present at the control electrodes ESP1 to 14 of the storage section SP. The instant t0 is considered to be the final instant of the picture integration period at the location of the electrode EIP14, while the storage section ESP no longer contains picture information. It is assumed that the shift register section SR, which is not shown, adjoins the storage section SP with the electrode ESP14. The number of fourteen electrodes has been taken for the sake of simplicity of the description, but in practice there are several hundreds of electrodes.

The instant t0 is succeeded by an instant t1 at which the logic pattern at the electrodes EIP is unchanged, while the logic pattern 0011 changes over to 1001 at the electrodes ESP. The result is that the picture information charge packet which is present under the electrode EIP14 extends as far as under the electrode ESP1. At a subsequent instant t2 the charge packet is present under the electrodes ESP1 and 2, while a widened barrier is present under the electrodes EIP14 and 13. At a subsequent instant t3 the charge packet under the electrode EIP12 has extended as far as under the electrode EIP13. Fig. 3 illustrates the charge packet extensions with a square changing into a rectangle. Subsequently only an information transfer takes place. It appears that an opening phase of the information shift in accordance with the accordion principle locally occurs with an enlargement of picture information elements (from square to rectangle) and a transport of picture information. To obtain a clear survey of the information shift, 0s have been omitted in Fig. 3.

For the instant t10 of Fig. 3 it is assumed that the logic pattern of 0s and 1s shown is present at the electrodes EIP and ESP. A comparison of Fig. 3 and Fig. 2a at the instant t10 shows that the shutter SH2 is considered to shield at least the electrodes EIP14, 13, 12, 11, 10 and 9. The continuing shielding is followed by the opening phase of the accordion transfer and Fig. 3 shows that the image section IP is completely shielded at an instant t11. As an example the instant t20 with the logic pattern shown, associated with Fig. 2b, is given.

At the instant t20 the closing phase of the accordion transfer starts at the electrode ESP14. A reduction of picture information elements at the appointed locations succeeds the transport of picture information in the transporting phase, as is illustrated by the rectangle and the square.

At an instant t21 the closing phase ends at the storage section SP, at the electrode ESP2. At an instant t22 the closing phase starts at the image section IP. Subsequently the image section IP is ready for the next picture information integration period at the location of the electrode EIP14. It is assumed that the logic pattern shown in Fig. 3 is associated with the instant t30 of Fig. 2c.

At an instant t31 the picture information from underneath the electrode EIP12 and stored under the electrode ESP12 is present under the electrodes ESP13 and 12. Before the instant t31 the picture information under the electrode ESP14 is passed on in a manner not shown to the adjacent shift register section SR. It will be evident from the further description of Fig. 3 that this picture information is incorrect.

At an instant t32 the picture information under the electrode EIP12 is passed on to the shift register section SR not shown and at the next instant t40 the shift register SR is entirely filled with picture information. A comparison of Fig. 2d at the instant t40 with the logic pattern shown in Fig. 3 illustrates that the shielding of the image section IP has been cancelled approximately halfway.

At an instant t41 or later the shielding of the image section IP is entirely cancelled and subsequently a state occurs as is shown in Fig. 1 with the continuous light integration.

For the storage section SP it holds that no clock pulses are applied thereto after the instant t40 during a subsequent line scan period associated with a picture signal. During the line scan period the parallel-in, series-out shift register section SR of Fig. 1 is controlled for the serial reading. In a subsequent line blanking period of the picture signal the shift register section SR is parallel filled from the storage section SP in a manner not shown.

It is assumed that the picture information under the electrode EIP2 and stored under the electrode ESP2 at an instant t42 is transported to the electrodes ESP14 and 13. Subsequently half of the picture information is present in the sections SR and SP of Fig. 1 at an instant t43, whereafter the section SR is entirely filled at the periodical instant t0. Fig. 3 shows that the same logic pattern is present at the two instants t0 shown.

During the transport of information shown by means of the arrow pointing to the instant t42 a periodical logic pattern 0011 occurs during transport at the electrode ESP1, as holds true for all electrodes. The instant t42 shows that the pattern 11 periodically occurs at the electrodes ESP2 and 1 and EIP14. Consequently picture information is periodically withdrawn under the electrode EIP14 so that the information ultimately being present under the electrode ESP14 after a subsequent frame transfer is incorrect picture information, as has been described in the foregoing. A measure against this may be the constant supply of a logic 0 to the electrode ESP1 during the period between the instants t41 and t43, at least during the last part thereof with the transport of information under the electrode ESP2. Instead of using the electrode ESP1, an extra electrode could be arranged at the bounding line between the storage section SP and the image section IP for forming the barrier.

It follows from the charge pattern at the instants t0 shown in Fig. 3 that interlacing has not been taken into account. For two interlaced fields the patterns 1010 etc. and 0101 etc. occur at the image section IP.

It follows from Fig. 3 and the description that in the case of a partly local interruption of the incidence of light radiation on the image section IP (instant t10 and Fig. 2a) the information transfer in accordance with the accordion principle locally starts at this interruption and follows it with the continuing local interruption of the incidence of light radiation. The fact that the accordion transfer is congruent with the interruption of the incidence of light radiation leads to a smooth frame transfer instead of to the known abrupt frame transfer in which, after an interruption of the incidence of light radiation at the entire image section IP, the information from this section is transferred in one single simultaneous action to the storage section SP. For the extremes shown in Fig. 3 there is a transfer between the instants t1 and t20 for the charge packet under the electrode EIP14 and between the instants t11 and t21 for the charge packet under the electrode EIP2. The effect that the local interruption of the incidence of light radiation is offset with respect to time leads to the generation of the picture signal with a described picture disturbance which is reduced upon display.

Fig. 1 and Figs. 2a, 2b, 2c and 2d show that the shutter device (SH, SHM) interrupts the light radiation parallel to the bounding line between the storage section SP and the image section IP. This provides a contiguous and subsequent frame transfer in accordance with the accordion principle, as is described by means of the logic pattern in Fig. 3.

The (extension) rate of the accordion transfer need not be equal to the rate v of the shutters SH1 and SH2. The extension rate of the opening phase of the accordion transfer during the period between the instants t1 and t11 of Fig. 3 may be smaller than or equal to the rate v. During closing in the period between the instants t22 and t41 the rate may be larger than or equal to the rate v. The smaller the rate v, the better the displayed picture quality.

## Claims

1. An image pick-up device comprising a frame transfer sensor suitable for information transfer in accordance with the accordion principle, which sensor comprises an image section comprising sensor image elements for converting incident radiation into charge packet information as picture information, a storage section coupled thereto and shielded from radiation for the purpose of picture information storage comprising sensor storage elements and a parallel-in, series-out shift register section coupled thereto and shielded from radiation comprising at least one row of sensor shift register elements and having at least one output for supplying a picture signal, the device for performing the accordion control including a time signal generator for applying at least clock pulse signals to control electrodes of the sensor, the information transfer in accordance with the accordion principle involving an information shift in the sensor with an opening, a transporting and a closing phase, the opening phase involving an enlargement of picture information elements and a transport of picture information, the transporting phase involving a transport of picture information and the closing phase involving a transport of picture information and a reduction of picture information elements at the appointed locations, said image pick-up device further including a shutter device for interrupting the incidence of radiation on the image section during a period for the information transfer in accordance with the accordion principle, characterized in that in the case of a partially local interruption of the incidence of radiation on the image section the information transfer in accordance with the accordion principle locally starts at said interruption and follows it with the continuing local interruption of the incidence of radiation.

2. An image pick-up device as claimed in Claim 1, characterized in that the shutter device interrupts the incidence of radiation parallel to the bounding line between storage section and image section.

**FIG.1**

**FIG.2a**

**FIG.2b**

**FIG.2c**

**FIG.2d**

|  | ESP |  |  |  |  |  |  | EIP |  |  |  |  |  |  |
|---|---|---|---|---|---|---|---|---|---|---|---|---|---|---|
|  | 14 | 12 | 10 | 8 | 6 | 4 | 2 | 14 | 12 | 10 | 8 | 6 | 4 | 2 |
|  | 13 | 11 | 9 | 7 | 5 | 3 | 1 | 13 | 11 | 9 | 7 | 5 | 3 | 1 |

FIG.3

FTD

2-Ⅱ-PHN 12722

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A,D | PHILIPS TECHNICAL REVIEW, vol. 43, nrs. 1/2, December 1986, pages 1-8; THEUWISSEN et al.: "The accordion imager, a new solid-state image sensor" * Page 1, right column, line 8 - page 2, left column, line 16; page 3, left column, line 30 - page 6, left column, line 20; figures 1,4 * | 1 | H 04 N 5/335 H 04 N 3/15 |
| A | PATENT ABSTRACTS OF JAPAN, vol. 7, no. 99 (E-172)[1244], 27th April 1983; & JP-A-58 20 076 | 2 | |
| A | PATENT ABSTRACTS OF JAPAN, vol. 7, no. 226 (E-202)[133], 7th October 1983; & JP-A-58 116 879 | 1 | |
| A | US-A-4 571 629 (HORIO et al.) * Column 4, lines 45-57; figure 4 * | 1 | |

TECHNICAL FIELDS SEARCHED (Int. Cl.5)

H 04 N 5
H 04 N 3
H 01 L 27

The present search report has been drawn up for all claims

| Place of search | Date of completion of the search | Examiner |
|---|---|---|
| THE HAGUE | 26-01-1990 | DUHR R.H.J.E. |